# EUROPEAN PATENT APPLICATION

(11) **EP 4 607 209 A1**
(43) Date of publication of application: **27.08.2025**
(21) Application number: 24159076.9
(22) Date of filing: 22.02.2024
(51) Int. Cl.: G01R 19/165, G01R 27/28

(54) **VOLTAGE LIMITER MODULE, DIRECTIVE MODULE, AND MEASUREMENT INSTRUMENT**

(71) Applicant: Rohde & Schwarz GmbH & Co. KG, 81671 München (DE)
(72) Inventor: Weiss, Markus, 81671 München (DE); Huber, Florian, 81671 München (DE); Rabenstein, Thomas, 81671 München (DE)
(74) Representative: Prinz & Partner mbB

(57) **Abstract**

A voltage limiter module (14) for limiting a voltage applied to an electronic structure is described. The voltage limiter module (14) comprises a first port (36) being connectable to a device under test. The voltage limiter module (14) further comprises a second port (38) being connectable to the electronic structure. The voltage limiter module (14) comprises a transmission line (40) connecting the first port (36) and the second port (38). The voltage limiter module (14) comprises a positive voltage limiter unit (48) that is configured to limit a positive voltage portion on the transmission line (40) to a threshold. The voltage limiter module (14) further comprises a negative voltage limiter unit (46) that is configured to limit a negative voltage portion on the transmission line (40) to a threshold. Further, a directive module (18) and a measurement instrument are described.

## Description

The present invention generally relates to a voltage limiter module for limiting a voltage applied to an electronic structure. The present invention further relates to a directive module and to a measurement instrument.

As is well-known in the state of the art, certain types of electronic structures need to be protected from overvoltages, for example from overvoltages due to electrostatic discharges, in order to avoid damages to the electronic structure.

Therein, it is desirable that the corresponding voltage limiter structures limiting the voltage applied to the electronic structure impair the functionality of the electronic structure as little as possible.

For example, voltage limiter structures used in measurement instruments should be configured such that impairments of the bandwidth of the measurement instrument are kept to a minimum.

The object of the present invention is to provide a voltage limiter module, a directive module, and a measurement instrument that allow for a reliable overvoltage protection and a high bandwidth.

According to the present invention, the problem is solved by a voltage limiter module for limiting a voltage applied to an electronic structure. The voltage limiter module comprises a first port being connectable to a device under test. The voltage limiter module further comprises a second port being connectable to the electronic structure. The voltage limiter module comprises a transmission line connecting the first port and the second port. The voltage limiter module comprises a positive voltage limiter unit that is configured to limit a positive voltage portion on the transmission line to a threshold. The voltage limiter module further comprises a negative voltage limiter unit that is configured to limit a negative voltage portion on the transmission line to a threshold.

Therein and in the following, the term "module" is understood to denote electronic circuitry that is configured to have the described functionality or rather perform the described functionality.

Likewise, the term "unit" is understood to denote electronic circuitry that is configured to have or rather perform the described functionality.

According to the present invention two types of different voltage limiter units are provided that are connected to the transmission line connecting the first port and the second port, namely the positive voltage limiter unit and the negative voltage limiter unit.

These two types of different voltage limiter units ensure that neither positive nor negative overvoltages damage an electronic structure that is connected to the second port.

It has turned out that the voltage limiter module according to the present invention is suitable for protecting the electronic structure connected to the second port in a wide frequency range from direct current, i.e. 0 Hz, up to for example 54 GHz.

In fact, the voltage limiter module according to the present invention reliably protects the electronic structure connected to the second port from electrostatic discharges up to about 8 kV.

According to an aspect of the present invention, the transmission line comprises a plurality of transmission line sections, wherein neighboring transmission line sections have different impedances, particularly wherein the neighboring transmission line sections have different widths. In other words, the impedance, particularly the width, of the transmission line is alternating between different values along the path from the first port to the second port. In fact, the transmission line may comprise a plurality of transmission line sections having larger impedance, particularly smaller width, and a plurality of transmission line sections having smaller impedance, particularly greater width. It has turned out that transmission characteristics of the voltage limiter module are enhanced over the relevant frequency spectrum due to the plurality of transmission line sections having different impedances. More precisely, it has turned out that resonance modes in the transmission characteristics are flattened.

The different impedances of the neighboring transmission line sections may be caused by the neighboring transmission line sections having different widths, wherein a smaller width corresponds to a larger impedance and vice versa.

In fact, each transmission line section may have one of two different impedances, particularly one of two different widths.

In fact, the transmission line sections may comprise a first type of transmission line sections and a second type of transmission line sections, wherein the impedance of the first type of transmission line sections is smaller than a first predefined impedance threshold, and wherein the impedance of the second type of transmission line sections is larger than a second predefined impedance threshold.

In other words, the width of the first type of transmission line sections may be greater than a first predefined width threshold, and the width of the second type of transmission line sections may be smaller than a second predefined width threshold.

The first predefined impedance threshold and the second predefined impedance threshold may be equal to each other. Alternatively, the first predefined impedance threshold may be smaller than the second predefined impedance threshold.

Likewise, the first predefined width threshold and the second predefined width threshold may be equal to each other. Alternatively, the first predefined width threshold may be greater than the second predefined width threshold.

Therein and in the following, the term "width" is understood to denote a dimension of the transmission line sections that is perpendicular to the axial direction of the transmission line extending between the first port and the second port and that is parallel to a substrate on which the transmission line is provided.

In fact, the transmission line sections may have a pairwise equal thickness. Particularly, the thickness of the transmission line may be constant between the first port and the second port.

In an embodiment of the present invention, all transmission line sections with a smaller impedance compared to neighboring transmission line sections have the same impedance, and/or wherein all transmission line sections with a larger impedance compared to neighboring transmission line sections have the same impedance. It has turned out that the transmission characteristics of the voltage limiter module can be further enhanced over the relevant frequency spectrum by choosing the same impedance, particularly the same width, for the transmission line sections having smaller impedance and/or by choosing the same impedance, particularly the same width, for the transmission line sections having greater impedance.

Accordingly, all transmission line sections with a smaller width compared to neighboring transmission line sections may have the same width, and/or all transmission line sections with a greater width compared to neighboring transmission line sections may have the same width.

According to another aspect of the present invention, the negative voltage limiter unit is connected to the transmission line sections having a smaller impedance compared to neighboring transmission line sections, particularly wherein the negative voltage limiter unit is connected to respective centers of the transmission line sections having the smaller impedance. Thus, the negative voltage limiter unit may be connected to the transmission line sections having a greater width compared to neighboring transmission line sections, particularly wherein the negative voltage limiter unit is connected to respective centers of the transmission line sections having the greater width. In general, the transmission line sections having greater width have a larger capacitance and a smaller inductance than the transmission line sections having smaller width. It has turned out that the transmission characteristics of the voltage limiting module can be further enhanced by connecting the negative voltage limiting unit to the transmission line sections having larger capacitance.

In a further embodiment of the present invention, the positive voltage limiter unit is connected to the transmission line sections having a larger impedance compared to neighboring transmission line sections, particularly wherein the positive voltage limiter unit is connected to respective centers of the transmission line sections having the larger impedance. Thus, the positive voltage limiter unit may be connected to the transmission line sections having a smaller width compared to neighboring transmission line sections, particularly wherein the positive voltage limiter unit may be connected to respective centers of the transmission line sections having the smaller width. In general, the transmission line sections having smaller width have a larger inductance and a smaller capacitance than the transmission line sections having greater width. It has turned out that the transmission characteristics of the voltage limiting module can be further enhanced by connecting the positive voltage limiting unit to the transmission line sections having larger inductance.

Another aspect of the present invention provides that the negative voltage limiter unit comprises a first set of diodes and a second set of diodes, wherein the first set of diodes is interconnected between a first reference potential and a first one of the transmission line sections having the smaller impedance, particularly the greater width, and wherein the second set of diodes is interconnected between the first reference potential and a second one of the transmission line sections having the smaller impedance, particularly the greater width, particularly wherein the first reference potential is ground or a constant DC potential. The first set of diodes and the second set of diodes may be connected to different transmission line sections, such that contact points between the sets of diodes and the transmission line are spaced differently from the first port. It has turned out that this further enhances the transmission characteristics of the voltage limiting module.

If the first reference potential is the constant DC potential, the first reference potential may be a negative voltage. This may increase a linearity of the voltage limiter module.

The first set of diodes may comprise a plurality of diodes that are serially connected with each other.

The first set of diodes may comprise at least three diodes, for example four, five, six, or more diodes.

Likewise, the second set of diodes may comprise a plurality of diodes that are serially connected with each other.

The second set of diodes may comprise at least three diodes, for example four, five, six, or more diodes.

The diodes of the first set of diodes and/or the diodes of the second set of diodes may be PIN diodes, respectively. However, it is to be understood that any other suitable type of diodes may be used.

In an embodiment of the present invention, contact points between the sets of diodes of the negative voltage limiter unit and the transmission line are spaced differently from the first port. In other words, a first contact point between the first set of diodes and the transmission line may have a first distance from the first port, wherein a second contact point between the second set of diodes and the transmission line may have a second distance from the first port, wherein the first distance is different from the second distance. It has turned out that this enhances the transmission characteristics of the voltage limiting module even if the transmission line has a uniform width along its complete length.

In a further embodiment of the present invention, cathodes of the first set of diodes and of the second set of diodes are facing the transmission line. This way, negative overvoltages can be reliably avoided from damaging electronic structures connected to the second port.

According to a further aspect of the present invention, the first set of diodes and the second set of diodes are connected to different transmission line sections. Thus, contact points between the sets of diodes of the negative voltage limiter unit and the transmission line are spaced differently from the first port. It has turned out that this further enhances the transmission characteristics of the voltage limiting module.

Another aspect of the present invention provides that the positive voltage limiter unit comprises a first set of diodes and a second set of diodes, wherein the first set of diodes is interconnected between a second reference potential and a first one of the transmission line sections having the larger impedance, particularly the smaller width, and wherein the second set of diodes is interconnected between the second reference potential and a second one of the transmission line sections having the larger impedance, particularly the smaller width, particularly wherein the second reference potential is ground or a constant DC potential. The first set of diodes and the second set of diodes may be connected to different transmission line sections, such that contact points between the sets of diodes and the transmission line are spaced differently from the first port. It has turned out that this further enhances the transmission characteristics of the voltage limiting module.

If the first reference potential is the constant DC potential, the first reference potential may be a positive voltage. This may increase a linearity of the voltage limiter module.

In general, the first reference potential may be equal to the second reference potential. For example, both the first reference potential and the second reference potential may be ground.

However, the first reference potential and the second reference potential may also be different from each other. For example, the first reference potential may be a negative constant DC voltage, while the second reference potential may be a positive constant DC voltage.

The first set of diodes may comprise a plurality of diodes that are serially connected with each other.

The first set of diodes may comprise at least three diodes, for example four, five, six, or more diodes.

Likewise, the second set of diodes may comprise a plurality of diodes that are serially connected with each other.

The second set of diodes may comprise at least three diodes, for example four, five, six, or more diodes.

The diodes of the first set of diodes and/or the diodes of the second set of diodes may be PIN diodes, respectively. However, it is to be understood that any other suitable type of diodes may be used.

According to an aspect of the present invention, contact points between the sets of diodes of the positive voltage limiter unit and the transmission line are spaced differently from the first port. In other words, a first contact point between the first set of diodes and the transmission line may have a first distance from the first port, wherein a second contact point between the second set of diodes and the transmission line may have a second distance from the first port, wherein the first distance is different from the second distance. It has turned out that this enhances the transmission characteristics of the voltage limiting module even if the transmission line has a uniform width along its complete length.

In an embodiment of the present invention, anodes of the first set of diodes and of the second set of diodes are facing the transmission line. This way, positive overvoltages can be reliably avoided from damaging electronic structures connected to the second port.

In fact, the first set of diodes and the second set of diodes may be connected to different transmission line sections. Thus, contact points between the sets of diodes of the positive voltage limiter unit and the transmission line are spaced differently from the first port. It has turned out that this further enhances the transmission characteristics of the voltage limiting module.

According to an aspect of the present invention, the transmission line sections have equal length. In fact, all transmission line sections may have equal length.

A further aspect of the present invention provides that the voltage limiter module is established as a monolithic microwave integrated circuit. Accordingly, a highly integrated voltage limiter module is provided. For example, the voltage limiter module may be provided on the same substrate as further electronic components or electronic structures that are connected to the second port.

According to the present invention, the problem further is solved by a directive module. The directive module comprises a plurality of ports, wherein the plurality of ports comprise a DUT port and at least two further ports. The DUT port is connectable to a device under test. The directive module is configured to selectively forward signals between the plurality of ports. The DUT port comprises or is connected to a voltage limiter module described above.

The at least one further port may comprise a REF port that is connected to a reference receiver.

Alternatively or additionally, the at least one further port may comprise a GEN port, wherein the GEN port is configured to receive a signal generated by a signal generator, e.g. a vector signal generator.

Alternatively or additionally, the at least one further port may comprise at least one MEAS port, wherein the at least one MEAS port may be connected to a measurement receiver being configured to perform measurements on signals received from the at least one MEAS port.

Regarding the advantages and further properties of the directive module, reference is made to the explanations given above with respect to the voltage limiter module, which also hold for the directive module and vice versa.

According to the present invention, the problem further is solved by a measurement instrument, particularly a vector network analyzer or a spectrum analyzer. The measurement instrument comprises a voltage limiter module described above and/or a directive module described above.

Regarding the advantages and further properties of the measurement instrument, reference is made to the explanations given above with respect to the voltage limiter module and the directive module, which also hold for the measurement instrument and vice versa.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a first variant of a measurement instrument according to the present invention;
- Figure 2 schematically shows a second variant of a measurement instrument according to the present invention;
- Figure 3 schematically shows a directive module according to the present invention;
- Figure 4a schematically shows a portion of a negative voltage limiter unit;
- Figure 4b schematically shows a portion of a positive voltage limiter unit; and
- Figure 5 shows several plots of transmission characteristics over frequency.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

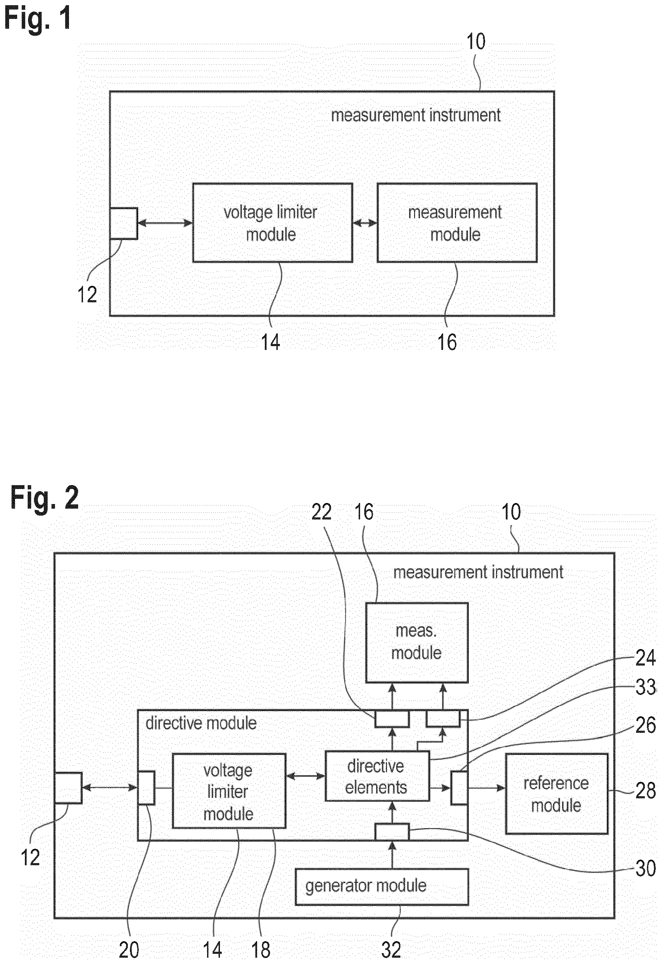

Figure 1 schematically shows a first exemplary embodiment of a measurement instrument 10 that is configured to perform measurements on an electronic device under test.

For example, the measurement instrument 10 may be a spectrum analyzer, a signal analyzer, a vector signal analyzer, or an oscilloscope, particularly a digital oscilloscope.

The measurement instrument 10 comprises a DUT connector 12 that is configured to be connected to the electronic device under test.

For example the DUT connector 12 may be a port that is integrated into a housing of the measurement instrument 10.

In the exemplary embodiment shown in Figure 1, the measurement instrument 10 further comprises a voltage limiter module 14, and a measurement module 16.

The voltage limiter module 14 is interconnected between the DUT connector 12 and the measurement module 16.

In general, the voltage limiter module 14 is configured to limit a voltage applied to electronic structures downstream of the voltage limiter module 14, particularly to the measurement module 16.

More precisely, the voltage limiter module 14 is configured to forward a signal received from the device under test via the DUT connector 12 to the measurement module 16, while simultaneously limiting the voltage applied to the measurement module 16.

The functionality and structure of the voltage limiter module 14 will be described in more detail below.

The measurement module 16 is configured to perform measurements on the signal received from the device under test, e.g. in order to assess a performance of the device under test.

Figure 2 shows a second exemplary variant of a measurement instrument 10, wherein only the differences compared to the first variant described above are explained hereinafter.

For example, the measurement instrument 10 shown in Figure 2 may be a vector network analyzer.

The measurement instrument 10 comprises a directive module 18 that is connected to the DUT connector 12.

In the exemplary embodiment shown in figure 2, the directive module 18 comprises the voltage limiter module 14 described above.

However, it is also conceivable that the directive module 18 and the voltage limiter module 14 may be established separately from each other.

The directive module 18 comprises a DUT port 20 that is connected to the DUT connector 12 of the measurement instrument 10. Accordingly, the DUT port 20 is connectable to an electronic device under test via the DUT connector 12.

It is noted that further components, e.g. amplifiers, attenuators, filters, etc. may be provided between the DUT port 20 and the DUT connector 12. These additional components may be provided separately from the directive module 18, particularly not on the same substrate.

The directive module 18 further comprises at least one MEAS port that is connected to the measurement module 16.

In the exemplary case shown in Figure 2, the directive module 18 comprises a first MEAS port 22 and a second MEAS port 24 for performing differential measurements.

The measurement module 16 may comprise further components such as a filter, an analog-to-digital converter, a mixer, etc. These additional components may be provided separately from the directive module 18, particularly not on the same substrate, and/or may be integrated into the directive module 18.

For example, the mixer of the measurement module 16 may be provided on the same substrate as the directive module 18.

The directive module 18 further comprises a REF port 26 that is connected to a reference module 28 of the measurement instrument 10.

For example, the reference module 28 may be a reference receiver.

The reference module 28 may comprise further components such as a filter, an analog-to-digital converter, a mixer, etc. These additional components may be provided separately from the directive module 18, particularly not on the same substrate.

Moreover, the directive module 18 comprises a GEN port 30 that is connected to a generator module 32 of the measurement instrument 10.

The generator module 32 may be or comprise a signal generator, particularly a vector signal generator.

The generator module 32 may comprise further components such as a filter, an analog-to-digital converter, a digital-to-analog converter, a mixer, etc. These additional components may be provided separately from the directive module 18, particularly not on the same substrate.

In general, the directive module 18 is configured to selectively forward signals between the DUT port 20, the MEAS ports 22, 24, the REF port 26, and the GEN port 30.

More precisely, the directive module 18 comprises directive elements 33 that are configured to selectively forward signals between the DUT port 20, the MEAS ports 22, 24, the REF port 26, and the GEN port 30.

For example, the directive elements 33 may comprise one or more directional couplers.

In a particular embodiment, the directive elements 33 may comprise a first directive element that is configured to forward a signal generated by the generator module 32 that is received by the GEN port 30 to the DUT port 20 and to the REF port 26.

The directive elements 33 may further comprise a second directive element that is configured to forward a signal travelling from the DUT port 20 towards components downstream of the DUT port 20, i.e. towards the other ports 22, 24, 26, 30, to the MEAS ports 22, 24.

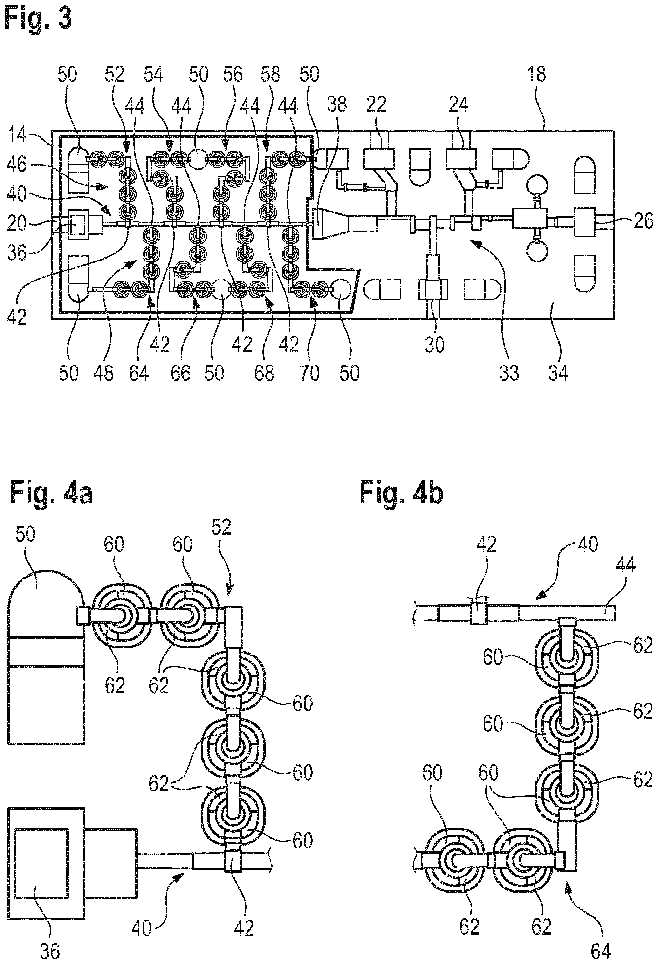

Figure 3 shows the directive module 18 with the voltage limiter module 14 in more detail.

The directive module 18 may comprise a substrate 34 on which the components described hereinafter are provided.

For example, the substrate 34 may comprise or consist of gallium arsenide or another suitable material or combination of materials.

In fact, the directive module 18 may be established as a monolithic microwave integrated circuit.

Optionally, the directive module 18 may comprise a housing that encloses the components of the directive module 18.

The voltage limiter module 14 comprises a first port 36 and a second port 38 that are connected with each other by a transmission line 40.

The first port 36 may be identical with or connected to the DUT port 20 of the directive module 18.

The transmission line 40 may be established as a metal stripe that is provided on the substrate 34.

In fact, the transmission line 40 may be a bidirectional transmission line, i.e. signals can be transmitted from the first port 36 to the second port 38 and from the second port 38 to the first port 36 by the transmission line 40.

The transmission line 40 comprises a plurality of transmission line sections, wherein neighboring transmission line sections have different impedances.

Particularly, the different impedances may be caused by the neighboring transmission line sections having different widths, wherein a smaller width corresponds to a larger impedance and a greater width corresponds to a smaller impedance.

Without restriction of generality, the exemplary case of the neighboring transmission line sections having different widths is described hereinafter.

In the exemplary embodiment shown in Figure 3, each transmission line section has one of two different widths and equal length.

Accordingly, the transmission line 40 comprises a first type 42 of transmission line sections having a first width and a second type 44 of transmission line sections having a second width, wherein the first width is greater than the second width.

Thus, all transmission line sections of the first type 42 have the same first width, and all transmission line sections of the second type 44 have the same second width.

However, it is to be understood that the individual transmission line sections may have more than two different widths and/or different lengths.

In general, the voltage limiter module 14 comprises a negative voltage limiter unit 46 that is configured to limit a negative voltage portion on the transmission line 40, as well as a positive voltage limiter unit 48 that is configured to limit a positive voltage portion on the transmission line 40.

The negative voltage limiter unit 46 comprises a plurality of sets of diodes that are interconnected between the transmission line 40 and a respective contact 50 to a first reference potential.

In general, the first reference potential may be ground or a constant DC potential, particularly a negative voltage.

In fact, the negative voltage limiter unit 46 comprises a first set of diodes 52, a second set of diodes 54, a third set of diodes 56, and a fourth set of diodes 58.

In general, the sets of diodes of the negative voltage limiter unit 46 are connected to the transmission line sections of the first type 42, particularly to a respective center of the transmission line sections.

More precisely, the first set of diodes 52 is connected to a first transmission line section of the first type 42 that is located closest to the first port 36.

The second set of diodes 54 is connected to a second transmission line section of the first type 42 that is located second-closest to the first port 36 and that is separated from the first transmission line section by one transmission line section of the second type 44.

The third set of diodes 56 is connected to a third transmission line section of the first type 42 that is located third-closest to the first port 36 and that is separated from the second transmission line section by one transmission line section of the second type 44.

The fourth set of diodes 58 is connected to a fourth transmission line section of the first type 42 that is located closest to the second port 38 and that is separated from the third transmission line section by one transmission line section of the second type 44.

As is exemplarily illustrated in Figure 4a for the first set of diodes 52 of the negative voltage limiter unit 46, the individual diodes are arranged in a serial connection between the transmission line 40 and the contact 50.

Therein, the cathodes 60 of the individual diodes are facing the transmission line 40, while the anodes 62 of the individual diodes are facing the contact 50.

Thus, the cathode 60 of a first one of the diodes is connected to the transmission line 40 directly. The cathode 60 of a second one of the diodes is connected to the anode 62 of the first one of the diodes, etc.

Similarly to the negative voltage limiter unit 46, the positive voltage limiter unit 48 comprises a plurality of sets of diodes that are interconnected between the transmission line 40 and a respective contact 50 to a second reference potential.

In general, the second reference potential may be ground or a constant DC potential, particularly a positive voltage.

In fact, the first reference potential may be equal to the second reference potential. For example, both the first reference potential and the second reference potential may be ground.

However, the first reference potential and the second reference potential may also be different from each other. For example, the first reference potential may be a negative constant DC voltage, while the second reference potential may be a positive constant DC voltage.

In fact, the positive voltage limiter unit 48 comprises a first set of diodes 64, a second set of diodes 66, a third set of diodes 68, and a fourth set of diodes 70.

In general, the sets of diodes of the positive voltage limiter unit 48 are connected to the transmission line sections of the second type 44, particularly to a respective center of the transmission line sections.

More precisely, the first set of diodes 64 is connected to a first transmission line section of the second type 44 that is located closest to the first port 36.

The second set of diodes 66 is connected to a second transmission line section of the second type 44 that is located second-closest to the first port 36 and that is separated from the first transmission line section by one transmission line section of the first type 42.

The third set of diodes 68 is connected to a third transmission line section of the second type 44 that is located third-closest to the first port 36 and that is separated from the second transmission line section by one transmission line section of the first type 42.

The fourth set of diodes 70 is connected to a fourth transmission line section of the second type 44 that is located closest to the second port 38 and that is separated from the third transmission line section by one transmission line section of the first type 42.

As is exemplarily illustrated in Figure 4b for the first set of diodes 64 of the positive voltage limiter unit 48, the individual diodes are arranged in a serial connection between the transmission line 40 and the contact 50.

Therein, the anodes 62 of the individual diodes are facing the transmission line 40, while the cathodes 60 of the individual diodes are facing the contact 50.

Thus, the anode 62 of a first one of the diodes is connected to the transmission line 40 directly. The anode 62 of a second one of the diodes is connected to the cathode 60 of the first one of the diodes, etc.

In the exemplary embodiment shown in Figures 3, 4a, and 4b, the individual sets of diodes comprise five diodes, respectively.

However, it is to be understood that the sets of diodes may comprise any other number of diodes greater than or equal to three.

The individual diodes may be established as PIN diodes or as another suitable type of diode.

In general, the voltage limiter module 14 described above protects all components downstream of the voltage limiter module 14, particularly the measurement module 16, the reference module 28, and/or the generator module 32 from overvoltages.

Therein, it has turned out that the voltage limiter module 14 described above provides improved transmission characteristics over a large frequency band, namely from 0 Hz, i.e. direct current, up to 54 GHz, and can reliably protect the downstream components from electrostatic discharges up to 8 kV.

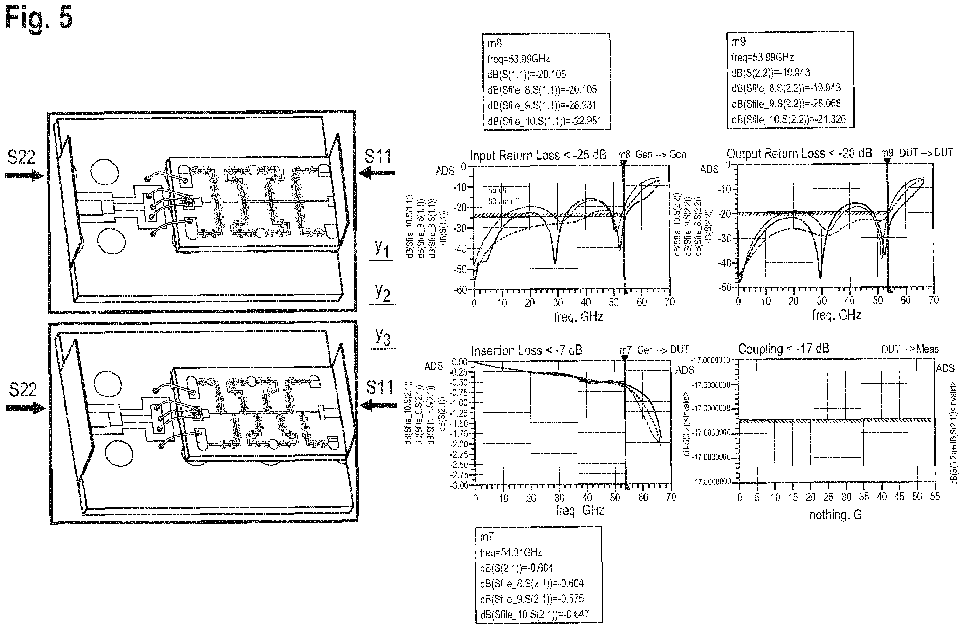

Figure 5 shows a comparison of different S-parameter plots, wherein *y*₁ corresponds to the results for a voltage limiter module configuration shown in the upper left hand side of Figure 5, *y*₃ corresponds to the voltage limiter module 14 describe above and shown in the lower left hand side of Figure 5, and *y*₂ corresponds to the voltage limiter module 14 describe above, but with a constant width of the transmission line 40 between the first port 36 and the second port 38.

As can be seen in Figure 5, providing the different sets of diodes with different distances from the first port 36 (*y*₂) already improves the transmission characteristics compared to *y*₁.

Providing the transmission line sections with alternating widths (*y*₃) further improves the transmission characteristics, particularly wherein resonance modes are flattened such that more uniform transmission characteristics are provided.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A voltage limiter module for limiting a voltage applied to an electronic structure,
wherein the voltage limiter module (14) comprises a first port (36) being connectable to a device under test, wherein the voltage limiter module (14) further comprises a second port (38) being connectable to the electronic structure,
wherein the voltage limiter module (14) comprises a transmission line (40) connecting the first port (36) and the second port (38),
wherein the voltage limiter module (14) comprises a positive voltage limiter unit (48) that is configured to limit a positive voltage portion on the transmission line (40) to a threshold, and
wherein the voltage limiter module (14) comprises a negative voltage limiter unit (46) that is configured to limit a negative voltage portion on the transmission line (40) to a threshold.

2. The voltage limiter module of claim 1, wherein the transmission line (40) comprises a plurality of transmission line sections, wherein neighboring transmission line sections have different impedances, particularly wherein the neighboring transmission line sections have different widths.

3. The voltage limiter module according to claim 2, wherein all transmission line sections with a smaller impedance compared to neighboring transmission line sections have the same impedance, and/or wherein all transmission line sections with a larger impedance compared to neighboring transmission line sections have the same impedance.

4. The voltage limiter module of claim 2 or 3, wherein the negative voltage limiter unit (46) is connected to the transmission line sections having a smaller impedance compared to neighboring transmission line sections, particularly wherein the negative voltage limiter unit (46) is connected to respective centers of the transmission line sections having the smaller impedance.

5. The voltage limiter module according to any one of claims 2 to 4, wherein the positive voltage limiter unit (48) is connected to the transmission line sections having a larger impedance compared to neighboring transmission line sections, particularly wherein the positive voltage limiter unit (48) is connected to respective centers of the transmission line sections having the larger impedance.

6. The voltage limiter module according to claim 4 or 5, wherein the negative voltage limiter unit (46) comprises a first set of diodes (52) and a second set of diodes (54), wherein the first set of diodes (52) is interconnected between a first reference potential and a first one of the transmission line sections having the smaller impedance, and wherein the second set of diodes (54) is interconnected between the first reference potential and a second one of the transmission line sections having the smaller impedance, particularly wherein the first reference potential is ground or a constant DC potential.

7. The voltage limiter module of claim 6, wherein cathodes (60) of the first set of diodes (52) and of the second set of diodes (54) are facing the transmission line (40).

8. The voltage limiter module of claim 6 or 7, wherein the first set of diodes (52) and the second set of diodes (54) are connected to different transmission line sections.

9. The voltage limiter module according to any one of claims 4 to 8, wherein the positive voltage limiter unit (48) comprises a first set of diodes (64) and a second set of diodes (66), wherein the first set of diodes (64) is interconnected between a second reference potential and a first one of the transmission line sections having the larger impedance, and wherein the second set of diodes (66) is interconnected between the first reference potential and a second one of the transmission line sections having the larger impedance, particularly wherein the second reference potential is ground or a constant DC potential.

10. The voltage limiter module of claim 9, wherein anodes (62) of the first set of diodes (64) and of the second set of diodes (66) are facing the transmission line (40).

11. The voltage limiter module of claim 9 or 10, wherein the first set of diodes (64) and the second set of diodes (66)are connected to different transmission line sections.

12. The voltage limiter module according to any one of claims 2 to 11, wherein the transmission line sections have equal length.

13. The voltage limiter module according to any one of the preceding claims, wherein the voltage limiter module (14) is established as a monolithic microwave integrated circuit.

14. A directive module, the directive module (18) comprising a plurality of ports, wherein the plurality of ports comprise a DUT port (20) and at least two further ports, wherein the DUT port (20) is connectable to a device under test, wherein the directive module (18) is configured to selectively forward signals between the plurality of ports, and wherein the DUT port (20) comprises or is connected to a voltage limiter module (14) according to any one of the preceding claims.

15. A measurement instrument, particularly a vector network analyzer or a spectrum analyzer, comprising a voltage limiter module (14) according to any one of claims 1 to 13 and/or a directive module (18) according to claim 14.
